Europäisches Patentamt

European Patent Office

Office européen des brevets

(11) Publication number: **0 610 995 A2**

# EUROPEAN PATENT APPLICATION

(21) Application number: **94200253.6**

(22) Date of filing: **31.01.94**

(51) Int. Cl.5: **H03L 7/107**, H03C 3/09

(30) Priority: **09.02.93 IT MI930213**

(43) Date of publication of application:
**17.08.94 Bulletin 94/33**

(84) Designated Contracting States:
**DE ES FR GB NL**

(71) Applicant: **ITALTEL SOCIETA ITALIANA
TELECOMUNICAZIONI s.p.a.**
**P.le Zavattari, 12**
**I-20149 Milano (IT)**

(72) Inventor: **Mondani, Giovanni**
**Via Cesare Battisti, 13**
**I-20010 Vittuone (IT)**
Inventor: **Esposito, Claudio**
**Via Mario Borsa, 34**
**I-20151 Milano (IT)**

(74) Representative: **Giustini, Delio**
**c/o Italtel Società Italiana**
**Telecomunicazioni s.p.a.**
**P.O. Box 10**
**I-20019 Settimo Milanese (MI) (IT)**

(54) **PLL frequency synthesizer, in particular for frequency hopping systems with direct frequency modulation.**

(57) PLL frequency synthesizer suitable to carry out fast frequency hopping and to modulate directly the generated frequency. It includes broadband filtering means (LB) for the quick transition during the hop from one frequency to another, and narrow band filtering means (BS) for the operation conditions.

The narrowband filtering means (BS) include:
- a sample and hold circuit (SH);
- a narrow band filter (RS);
- a buffer connected between said sample and hold circuit (SH) and said narrow band filter (RS).

Fig.3

## Field of the Invention

The present invention relates generally to a frequency sythesizer, and in particular to a device suitable to synthesize rapidly one or more assigned frequencies for applications in digital transmission systems of the commercial type, in particular for the use in cordless telephony systems (for example the DECT system) providing for the frequency hopping in the transmission of subsequent time slots of a same signal frame.

## Background Art

For the rapid frequency synthesis the so-called "direct digital synthesizer" systems are known, but these are expensive and sophisticated so to be used only in special applications.

Another solution generally proposed to obtain the rapid hopping from one frequency to another is that to use two separate alternatively switched PLL synthesizers and programming the next frequency on the one which is temporarily not in use. This system turns out to be less complicate from a constructive point of view, but it is more expensive, requiring a high energy drain in addition to the fact that it involves shielding problems in order to avoid leakage, which will consequently increase the cost and the weight.

Therefore the synthesizer devices for the use in "consumer" type equipment are preferably of the type including a single circuit with phase locked feedback loop (PLL).

The characteristics generally requested to this type of synthesizer are a high locking speed to carry out rapidly the hopping from one frequency to the following one, a reasonable cost and a limited power drain, in particular in the case of application in portable sets. As an indication in a DECT system scheduling a time slot duration assigned to a subscriber of about 500 μsec the response time of the device on a new frequency must be less than 50 μsec.

In addition to this from the moment that the synthesized signal must be afterwards modulated, the cutoff frequency of the feedback loop must be lower than the minimum modulating frequency if it is intended to modulate directly within the loop.

In US-A 4 937 536 is disclosed a synthesizer circuit with phase locked loop where - during the transitory phase of hopping from one frequency to another - a loop filter with a high cutoff frequency and therefore with low time constant is used to obtain the rapid transition. Instead in the operation conditions a loop filter with low cutoff frequency is used and therefore with high time constant.

In order to make the switching from the operation with the first loop to that with the second loop without discontinuity of the synthesized frequency, the device of the US patent provides that, at the moment of switching, the filter of the second loop already shows up in the initial correct conditions, that is the capacitor having proportional value to the time constant of the filter presents itself charged at the proper voltage of the functioning with closed loop. The higher the capacity of the capacitor of the second loop filter is with respect to that of the first loop, the lower is the cutoff frequency of the second loop compared to that of the first. However with the increase of this capacity increases also the intensity of the necessary charging current (at the same time employed for the charging of the capacitor), and therefore it constitutes a drawback.

Moreover the circuit described in the US patent does not face the problem of the modulation and requires a phase comparator suitable to generate a voltage proportional to the phase difference of the two input signals, and therefore suitable to generate a voltage equal to zero in locking conditions, which involves problems due to the unavoidable presence of an offset voltage.

## Object of the Invention

It is the object of the present invention to overcome the above-mentioned drawbacks and limitations of the known devices and in particular to realize the modulation of the synthesized signal in the same loop, to obtain high locking speeds and to reduce the dimensions and the cost of the synthesizer.

## Disclosure of the Invention

These objects are achieved by the invention consisting of a PLL frequency synthesizer in particular for frequency hopping systems with direct frequency modulation, including:
- a voltage controlled oscillator,
- a phase comparator generating an error signal proportional to the difference between the output frequency of the oscillator and a reference frequency,
- broad band filtering means inserted in the feedback loop and which output constitutes a control signal for said controlled oscillator,
- narrow band filtering means comprising a capacitor and suitable to be inserted in the feedback loop in parallel to said broad band filtering means;
- switching means for the realization of said insertion;
    said synthesizer being characterized in that said narrow band filtering means include:
- a narrow band filter;

- a sample and hold circuit including said capacitor and
- a first buffer circuit, connected between said narrow band filter and said sample and hold circuit, to bring the sampled voltage as reference of the narrow band filter.

Further advantageous characteristics are the subject of the appended claims.

Brief Description of the Drawings

The structural and functional characteristics and the advantages in terms of services of the device according to the invention will be better understood by the exemplifying and not limiting description hereafter together with the enclosed drawings where:

figure 1 shows schematically a transceiver equipment in which the synthesizer according to the invention has been incorporated;

figure 2 is a diagram of an embodiment of the synthesizer SIN of figure 1 with feedback loop comprising two filters according to the present invention; and

figure 3 shows in details a synthesizer according to the present invention.

Detailed Description of the Preferred Embodiment

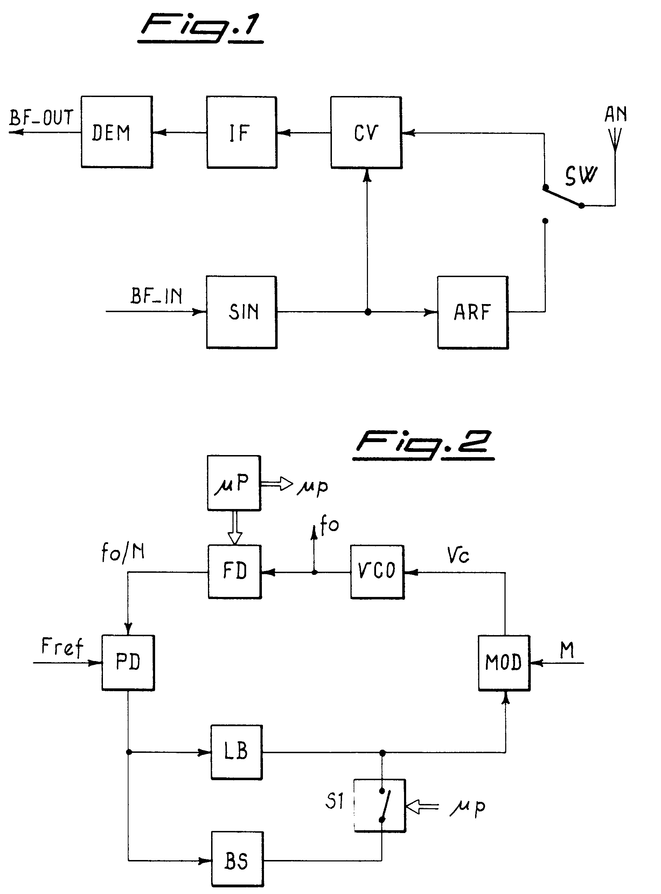

Referring to the general diagram of figure 1 the illustrated transceiver comprises an antenna AN alternatively connectible through a switch SW to a transmission line IN and a reception line OUT. The transmission line comprises a radio frequency amplifier ARF and a synthesizer SIN modulated by a low frequency signal BF-IN, while the reception line comprises a reception converter or mixer CV and the same synthesizer SIN, used in this case as a heterodyne, with the output of the converter CV connected to the intermediate frequency circuits IF and to a demodulator DEM supplying in output a low frequency signal BF-OUT.

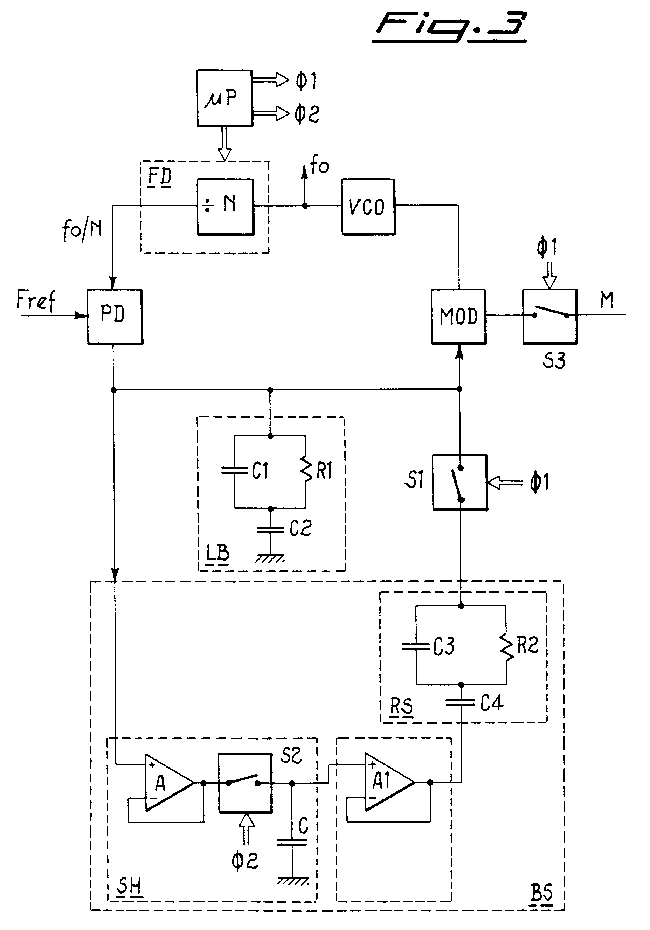

The synthesizer according to the invention will be illustrated with reference to figure 2. It includes a voltage-controlled oscillator VCO supplying in output a frequency fo. The output of the VCO is furthermore connected to a frequency divider FD dividing the frequency of the incoming signal by a selectable factor N, normally through a control micro-processor $\mu$P. In the case of the preferred application of the invention in a DECT system the unitary variation of the frequency in output of the divider is of 1728 kHz. According to an alternative embodiment of the invention, the frequency divider FD has a fixed value and the reference frequency can be programmed through the microprocessor $\mu$P.

The output of the frequency divider FD is brought to a phase comparator PD which receives in input also a reference frequency Fref and which produces in output a current proportional to the difference between the frequency fo/N and the reference frequency Fref. In alternative the phase comparator may behave as a voltage generator and in this case a high gain amplifier (not illustrated) is connected to the output of the comparator.

The output of the PD is connected in input to the two loop filters and in particular to broad band filtering means LB (about 100 kHz) and to narrow band filtering means BS (about 3 kHz), respectively. The narrow band filtering means BS are inserted in parallel in the feedback loop by means of a switch S1 controlled by the output $\mu$p of said microprocessor $\mu$P. The output of the filtering means LB and the other end of the switch S1 are connected to an adder MOD receiving on the other input the modulating signal M, and the output of the adder is connected to the control input of the VCO.

According to the invention, when a frequency hop is ordered, the broad band filtering means LB - making it possible to obtain rapidly (in times of 30 $\mu$sec) the locking on the new carrier frequency - are inserted in the feedback loop. Subsequently the narrow band filtering means BS are inserted making the direct modulation of the carrier up to a relatively low frequency (of 9KHz) possible. The modulating signal M is added to the output of LB and LS through the adder MOD which output constitutes the control signal Vc of the VCO under operation conditions.

The structure of the synthesizer according to the invention is shown more in detail in figure 3 where the same references are used as in figure 2 for the same or corresponding parts.

The filtering means LB are of the conventional type and provides for example for a capacitor C1 and a resistor R1 in parallel to each other and in series with another capacitor C2. The output of the filtering means LB are connected to the input of the adder MOD and to the output of the narrow band filter circuit BS through a switch S1.

The narrow band filtering means BS comprise a filter RS in the strict sense of the word, of narrow band type including a capacitor C3 and a resistor R2 in parallel to each other and in series to another capacitor C4. The filtering means BS comprise moreover a sampling and hold circuit SH realized through a feedback buffer A. The output of the buffer A is connected to the capacitor C and coupled to the filter RS through a circuit A1 operating as a buffer. The commanding signals $\phi$1 and $\phi$2 of the switches S1 and S2 are generated by the microprocessor $\mu$P. The locking is obtained using the loop set up by the filtering means LB so as to realize a fast locking which anyhow would not allow the modulation of the carrier, and therefore a second loop is switched in the circuit putting it "in parallel" to that which served for the fast lock. The capacitor C supplies a continuous voltage such to avoid discontinuity in the switching. A further switch (not shown) may be provided to physically disconnect the filter LB from the adder MOD.

Now the functioning of the circuit shown in figure 3 will be described, starting from the instant in which the frequency hopping is ordered.

In the instant in which through the microprocessor µP the ratio N of division of FD is modified from N1 to N2, the switch S2 is closed and the switch S1 opened. The modulating signal M is initially zero as it is applied through a switch S3, open during the frequency transient.

At the moment of transition from N1 to N2 the output frequency of the VCO is still given by fo = Fref.N1. This frequency, divided by N2 by means of the divider FD, becomes:

f = fo/N2 = Fref.(N1/N2)

which is different from Fref. It is compared with Fref in the phase comparator PD where, due to this diversity, a current is generated proportional to the difference (f-Fref). After the filtering in LB, this current produces a voltage at the input of the VCO such to correct the output frequency of the last one and bringing it to the value Fref.N2, that is the new operating frequency. The lock is therefore obtained by using the loop including the broad band filtering means LB with a small time constant and which makes it possible to obtain a rapid lock (for example of 30 µsec.), but makes not possible to modulate directly the carrier.

When the transient is exhausted, at the inputs of the phase comparator PD there are two signals present both of them at a frequency Fref and in phase to each other. At the output of the phase comparator PD corresponds therefore a current equal to zero and a high impedance, and consequently the control voltage Vc is maintained by LB. This voltage is brought back to the capacitor C of the SH circuit. A certain time is necessary to charge the capacitor C to the voltage Vc, but according to the invention it is possible to use low values for the capacity C in order to obtain its charge even with low current values.

When the voltage at the ends of the capacitor C is equal to VC, the switch S1 is closed and the switch S2 is opened and so the modulating signal M is applied through the switch S3 controlled by the same control signal φ1 of the switch S1. From the dynamic point of view the capacitor C4 may be considered as referred to ground and charged at the voltage Vc, and under these conditions it is possible to introduce the modulation without drawbacks adding to the control voltage Vc the signal M. In fact, if the capacity of C4 is sufficiently high, the time constant of the loop filter set up by the parallel of LB and RS turns out to be high too.

Therefore the loop is a narrow band one and does not correct the perturbations introduced by the signal M even if it has a relatively low frequency, and therefore the direct modulation of the carrier up to low frequencies (for example of 9 KHz in the case of a DECT application) turns out to be possible.

The synthesizer according to the invention does not require to charge the capacitor of the second loop filter (C4) as it is the case in the circuit of the patent US-A-4 937 536. In fact the filter is put to the initially correct conditions to avoid discontinuity in the frequency generated at the moment of the loop filter switching thanks to the sample and hold circuit and to the buffer A1.

The illustrated disposition makes it possible to use a capacitor C of small capacity without limiting the performance of the device.

The synthesizer according to the invention uses standard circuits and allows the direct modulation of the synthesized frequency.

Moreover the device eliminates the typical electromagnetic compatibility problems of the solutions employing two different synthesizers. In this way the transceiver equipment turns out to be of reasonable cost and dimension with limited current drain, allowing the construction of portable sets with small dimensions and great autonomy.

In short the final test of the equipment turns out to be simplified.

**Claims**

1. PLL frequency synthesizer including:
   - a voltage controlled oscillator (VCO),
   - a phase comparator (PD) generating an error signal proportional to the difference between the output frequency of the oscillator (fo) and a reference frequency (Fref),
   - broad band filtering means (LB) inserted in the feedback loop and which output constitutes a control signal for said controlled oscillator (VCO),
   - narrow band filtering means (BS) comprising a capacitor (C) and suitable to be inserted in the feedback loop in parallel to said broad band filtering means (LB);
   - switching means (S) for the realization of said insertion;
     said synthesizer being characterized in that said narrow band filtering means (BS) include:

- a narrow band filter (RS);
- a sample and hold circuit (SH) including said capacitor (C) and
- a first buffer circuit (A1), connected between said narrow band filter (RS) and said sample and hold circuit (SH), to bring the sampled voltage as reference of the narrow band filter.

2. Synthesizer according to claim 1, characterized in that said sample and hold circuit (SH) includes a second buffer circuit (A) with the output connectible by a first switch (S2) to said capacitor (C) through a first switch (S2).

3. Synthesizer according to claim 1, characterized in that it includes an adder (MOD) connected between the output of said broad band filtering means (LB) and the controlled oscillator (VCO) to add a modulating signal (M) to the control voltage (Vc) of the controlled oscillator (VCO).

4. Synthesizer according to claim 1, characterized in that said switching means (S) comprise a second switch (S1) connected between the output of the narrow band filter (RS) and the input of said adder (MOD).

5. Synthesizer according to any of claims from 1 to 4, characterized in that the output of said phase comparator (PD) behaves as a current generator.

6. Synthesizer according to any of the claims from 1 to 4, characterized in that said phase comparator (PD) behaves as a voltage generator, and that a high gain amplifier is connected between the output of the comparator (PD) and the input of the filters.

7. Synthesizer according to claims 5 or 6, characterized in that said frequency divider (FD) is programmed by means of a microprocessor ($\mu$P).

8. Synthesizer according to claims 5 and 6, characterized in that said frequency divider is fixed and the value of the reference frequency (Fref) is programmed by means of a microprocessor ($\mu$P).

9. Synthesizer according to claims 2 and 4, characterized in that it provides for a third switch (S3) to connect the modulating signal (M) in input to said adder (MOD).

10. Synthesizer according to claim 1, characterized in that it includes a fourth switch suitable to disconnect the broad band filter circuit (LB) from the feedback loop during the continuous running of the synthesizer itself.

11. Synthesizer according to claims 2, 4, 9 and 10, characterized in that said second and third switch (S1 and S3) are controlled by a first signal ($\phi$1), and the first and fourth switch (S2 and fourth switch) are controlled by a second signal ($\phi$2).

# _Fig.1_

BF_OUT ← DEM ← IF ← CV ← ... AN

SW

BF_IN → SIN → ARF

# _Fig.2_

µP ⇒ µp

fo

fo/M

FD ← VCO ← Vc

Fref → PD

MOD ← M

LB

S1 ⇐ µp

BS

# Fig.3